(19) Europäisches Patentamt
European Patent Office
Office européen des brevets

(11) **EP 4 631 718 A1**

(12) **EUROPEAN PATENT APPLICATION**
published in accordance with Art. 153(4) EPC

(43) Date of publication:
**15.10.2025 Bulletin 2025/42**

(21) Application number: **23900698.4**

(22) Date of filing: **06.12.2023**

(51) International Patent Classification (IPC):
**B32B 15/08** (2006.01)    **H05K 1/03** (2006.01)

(52) Cooperative Patent Classification (CPC):
**B32B 15/08; H05K 1/03**

(86) International application number:
**PCT/JP2023/043681**

(87) International publication number:
**WO 2024/122586 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.12.2022 JP 2022195976**

(71) Applicant: **Resonac Corporation
Tokyo 105-7325 (JP)**

(72) Inventors:
• **NAKANISHI Kota
Tokyo 105-7325 (JP)**

• **KITAJIMA Takayo
Tokyo 105-7325 (JP)**
• **TONOUCHI Shunsuke
Tokyo 105-7325 (JP)**
• **MAGOTA Seiya
Tokyo 105-7325 (JP)**
• **FUJITA Hiroaki
Tokyo 105-7325 (JP)**
• **TAKAHASHI Masaki
Tokyo 105-7325 (JP)**

(74) Representative: **Hoffmann Eitle
Patent- und Rechtsanwälte PartmbB
Arabellastraße 30
81925 München (DE)**

(54) **METAL-CLAD LAMINATED BOARD, PRINTED WIRING BOARD, AND SEMICONDUCTOR PACKAGE**

(57)    To provide a metal-clad laminate or the like which can reduce variation in the amount of warpage of a semiconductor package and has a small variation in the rate of dimensional change. Specifically, the metal-clad laminate is a metal-clad laminate including a metal foil and a cured product of one or more plies of a prepreg, in which an average thickness measured according to the following method using a laser displacement meter is 400 $\mu$m or more, and an average value of absolute values of differences between a maximum value and a minimum value of thicknesses is 20 $\mu$m or less. (Method for measuring thickness of metal-clad laminate) The thickness is measured by cutting out four measurement substrates each having a size of 60 mm (vertical) $\times$ 60 mm (horizontal) in a plane direction from an arbitrary portion of the metal-clad laminate. The measurement is performed at intervals of 1 mm in the vertical direction from a start point of less than 1 mm (however, not 0 mm) from the upper side; the measurement of the vertical line is performed for 12 lines; the first line is located 2.5 mm away from the left side, and measurement lines are provided at intervals of 5 mm thereafter; further, the thickness is measured at intervals of 1 mm in the horizontal direction from a start point of less than 1 mm (however, not 0 mm) from the left side; the measurement of the horizontal line is also performed for 12 lines; the first line is located 2.5 mm away from the upper side, and measurement lines are provided at intervals of 5 mm thereafter; details are as described in the description herein.

[Fig. 4]

Resin film
Non-impregnated region with thermosetting resin composition
Fiber substrate

EP 4 631 718 A1

**Description**

Technical Field

The present disclosure relates to a metal-clad laminate, a printed wiring board, and a semiconductor package.

Background Art

With the increase in density and miniaturization of semiconductor packages in recent years, there is a need for miniaturization technology of package circuits, miniaturization of solder bumps for connecting a semiconductor chip and an organic substrate or an interposer, and the like. In order to ensure high reliability with a miniaturized structure, it is necessary for a printed wiring board used for a semiconductor package to improve low warpage property, dimensional stability, and impedance control.

Focusing on the low warpage property, conventionally, an attempt has been made to reduce the warpage of the printed wiring board or the semiconductor package by examining an insulating resin material of a laminate, such as bringing a coefficient of thermal expansion of the insulating resin material of the laminate close to that of a silicon chip, adjusting an elastic modulus, and the like. For example, for the purpose of reducing the warpage and the like, PTL 1 discloses a prepreg formed of a resin composition containing a specific low elastic component and a woven fabric substrate, and PTL 2 discloses a resin composition having a specific maleimide compound and a specific silicone compound, and a prepreg formed using the resin composition.

Citation List

Patent Literature

> PTL 1:JP 2015-189834 A
> PTL 2:WO 2012/099134

Summary of Invention

Technical Problem

As described in PTLs 1 and 2, it is important to reduce the amount of warpage itself of the semiconductor package. However, further examination has revealed that reducing "variation in the amount of warpage" is also important from the viewpoint of ensuring reliability of the semiconductor package. Therefore, a new technical development capable of reducing variation in the amount of warpage of the semiconductor package is desired.

In addition, when a semiconductor package is produced, there is a process in which a build-up material is laminated on a laminate a plurality of times and then heated and cured. In a case where a variation in a rate of dimensional change is large in the laminate after passing through the heating and curing process, there is a concern that the pattern formed in a solder resist layer provided as the outermost layer is displaced, and the connection area of the solder bump connected to the semiconductor chip is reduced, thereby deteriorating reliability. Therefore, in order to ensure high reliability, it can be said that it is desirable that the variation in the rate of dimensional change during heating of the laminate is small.

Accordingly, an object of the present disclosure is to provide a metal-clad laminate capable of reducing variation in the amount of warpage of a semiconductor package and having a small variation in the rate of dimensional change, and to provide a printed wiring board and a semiconductor package.

Solution to Problem

As a result of the accumulated studies by the present inventors, it has been found that the object can be achieved by the present disclosure. The present disclosure includes the following items [1] to [7].

[1] A metal-clad laminate including a metal foil and a cured product of one or more plies of a prepreg, in which an average thickness measured according to the following method using a laser displacement meter is 400 $\mu$m or more, and an average value of absolute values of differences between a maximum value and a minimum value of thicknesses is 20 $\mu$m or less: (method for measuring thickness of metal-clad laminate)

the thickness is measured by cutting out four measurement substrates each having a size of 60 mm (vertical) × 60 mm (horizontal) in a plane direction from an arbitrary portion of the metal-clad laminate; the measurement is performed at intervals of 1 mm in the vertical direction from a start point of less than 1 mm (however, not 0 mm) from the upper side; the measurement of the vertical line is performed for 12 lines; the first line is located 2.5 mm away from the left side, and measurement lines are provided at intervals of 5 mm thereafter; further, the thickness is measured at intervals of 1 mm in the horizontal direction from a start point of less than 1 mm (however, not 0 mm) from the left side; the measurement of the horizontal line is also performed for 12 lines; the first line is located 2.5 mm away from the upper side, and measurement lines are provided at intervals of 5 mm thereafter;

the absolute value of the difference between the maximum value and the minimum value of the thickness of each of the four measurement substrates and the average value of the absolute values are obtained by extracting the maximum thickness and the minimum thickness from the thicknesses of all the points measured for each of the four measurement substrates; and further, the average thickness of all the points measured for the four measurement substrates is calculated, and this is taken as the average thickness of the metal-clad laminate.

[2] The metal-clad laminate according to the item [1], in which a value calculated from the following formula is 2.0% or less:

(average value of absolute values of differences between maximum value and minimum value of thicknesses) × 100/(average thickness of metal-clad laminate).

[3] The metal-clad laminate according to the item [1] or [2], in which the average value of the absolute values of the differences between the maximum value and the minimum value of the thicknesses is 16 μm or less.

[4] The metal-clad laminate according to any one of the items [1] to [3], in which the prepreg is a prepreg containing a fiber substrate having a thickness of 40 μm or more and a thermosetting resin composition.

[5] The metal-clad laminate according to any one of the items [1] to [4], in which the metal foil has a thickness of 1 to 200 μm.

[6] A printed wiring board including the metal-clad laminate according to any one of the items [1] to [5].

[7] A semiconductor package including the printed wiring board according to the item [6] and a semiconductor element.

Advantageous Effects of Invention

According to the present disclosure, it is possible to provide a metal-clad laminate in which the variation in the amount of warpage of a semiconductor package can be reduced and the variation in the rate of dimensional change is small, and it is possible to provide a printed wiring board and a semiconductor package.

Brief Description of Drawings

[Fig. 1] Fig. 1 is a schematic view ((a) and (b)) illustrating a method for measuring a thickness of a metal-clad laminate of the present embodiment.

[Fig. 2] Fig. 2 is a perspective view of an example of a measurement site of a non-contact type and sandwich type laser displacement meter used in measurement of a thickness of the metal-clad laminate of the present embodiment.

[Fig. 3] Fig. 3 is a schematic view of an example of a sensor head of a laser displacement meter used in measurement of a thickness of the metal-clad laminate of the present embodiment.

[Fig. 4] Fig. 4 is a schematic cross sectional view showing one embodiment of a prepreg used for the metal-clad laminate of the present embodiment.

[Fig. 5] Fig. 5 is a cross sectional view of a prepreg illustrating a thickness of a fiber substrate and resin thicknesses of resins on front and back sides thereof.

[Fig. 6] Fig. 6 is a surface observation image obtained by converting a surface observation image used in calculation of an existing ratio of an impregnated region into monochrome mode in the prepreg produced in Example 1.

[Fig. 7] Fig. 7 is a schematic view illustrating how to cut out four measurement substrates (N1 to N4) from predetermined portions at four corners of a copper-clad laminate when measuring the thickness of the copper-clad laminate in Examples and Comparative Examples.

[Fig. 8] Fig. 8 is a schematic view illustrating how to cut out four evaluation substrates from a copper-clad laminate when evaluating a variation in a rate of dimensional change of the copper-clad laminate in Examples and Comparative Examples.

Description of Embodiments

One embodiment of the present disclosure will be described below, but the present disclosure is not limited to the embodiment described below.

In the numerical range described in the present disclosure, the lower limit value or the upper limit value of the numerical range may be replaced by the value described in the examples. The lower limit value and the upper limit value of the numerical range may be optionally combined with the lower limit value and the upper limit value of another numerical range. In the notation of the numerical range "AA to BB", the numerical values AA and BB at both ends are included in the numerical range as the lower limit value and the upper limit value, respectively.

In the present disclosure, for example, the description of "10 or more" means 10 and a numerical value exceeding 10, and the same applies to a case where the numerical value is different. Further, for example, the description of "10 or less" means 10 and a numerical value less than 10, and the same applies to a case where the numerical value is different.

The components and materials exemplified in the present disclosure may be used alone or in combination of two or more kinds thereof, unless otherwise specified. In the present disclosure, in a case where multiple substances exist for each of the components in the thermosetting resin composition, the content of the component in the thermosetting resin composition means the total amount of the multiple substances existing in the thermosetting resin composition unless otherwise specified.

In the present disclosure, the "resin component" is defined as all the components of the solid content constituting the thermosetting resin composition except for the inorganic compound, such as the inorganic filler, the flame retardant, and the flame retardant aid, which are described later.

In the present disclosure, the "solid content" means a component other than a solvent, and a component that is liquid at 25°C is also regarded as a solid content.

In the expression "containing (a component) XX" described in the present disclosure, when (the component) XX can react, (the component) XX may be contained in a reacted state, (the component) XX may be simply contained as it is, or both of these aspects may be included.

An aspect in which matters described in the present disclosure are arbitrarily combined is also included in the present disclosure and the present embodiment.

[Metal-Clad Laminate]

The present disclosure relates to a metal-clad laminate including a metal foil and a cured product of one or more plies of a prepreg, in which an average thickness measured according to the following method using a laser displacement meter is 400 $\mu$m or more, and an average value of absolute values of differences between a maximum value and a minimum value of thicknesses is 20 $\mu$m or less.

(Method for measuring thickness of metal-clad laminate)

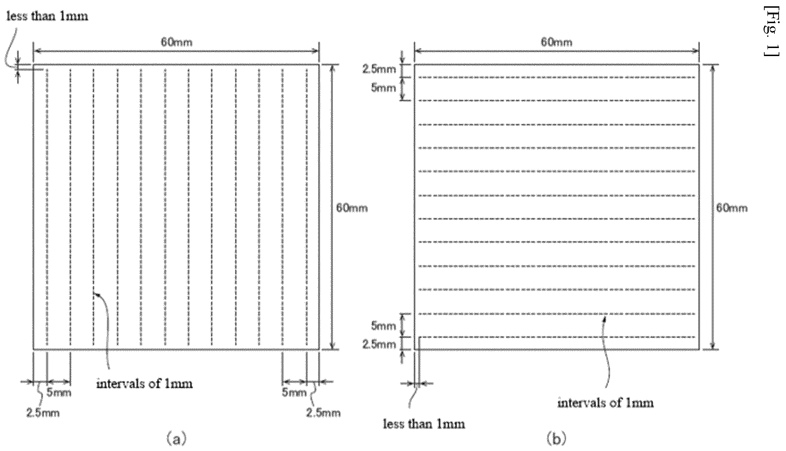

The thickness is measured by cutting out four measurement substrates each having a size of 60 mm (vertical) $\times$ 60 mm (horizontal) in a plane direction from an arbitrary portion of the metal-clad laminate. As shown in Fig. 1(a), the measurement is performed at intervals of 1 mm in the vertical direction from a start point of less than 1 mm (however, not 0 mm) from the upper side. The measurement of the vertical line is performed for 12 lines. The first line is located 2.5 mm away from the left side, and measurement lines are provided at intervals of 5 mm thereafter. Further, as shown in Fig. 1(b), the thickness is measured at intervals of 1 mm in the horizontal direction from a start point of less than 1 mm (however, not 0 mm) from the left side. The measurement of the horizontal line is also performed for 12 lines. The first line is located 2.5 mm away from the upper side, and measurement lines are provided at intervals of 5 mm thereafter.

The absolute value of the difference between the maximum value and the minimum value of the thickness of each of the four measurement substrates and the average value of the absolute values are obtained by extracting the maximum thickness and the minimum thickness from the thicknesses of all the points measured for each of the four measurement substrates. Further, the average thickness of all the points measured for the four measurement substrates is calculated, and this is taken as the average thickness of the metal-clad laminate.

The thickness measurement of the vertical line and the horizontal line may be performed for a total of 24 lines, and the order of the lines to be measured is not particularly limited. The measurement may be performed from the first line, the measurement may be performed from the twelfth line, or the measurement may be performed in any order.

However, when it is not possible to cut out four measurement substrates having a size of vertical 60 mm $\times$ horizontal 60 mm due to the size of the metal-clad laminate, the maximum number of substrates that can be cut out having a size of vertical 60 mm $\times$ horizontal 60 mm is substituted.

In addition, in a case where the metal-clad laminate has a square shape in which the size in the plane direction is equal to or less than the vertical 60 mm and equal to or less than the horizontal 60 mm, the metal-clad laminate is used as a measurement substrate as it is. On the other hand, in a case where the metal-clad laminate has a rectangular shape in which the size in the plane direction is equal to or less than the vertical 60 mm or equal to or less than the horizontal 60 mm, the metal-clad laminate cut into the largest square shape is used as a measurement substrate. The lower limit of the size in the plane direction of the measurement substrate is the vertical 20 mm or more × the horizontal 20 mm or more. In this case, since the widths of the measurement lines are the same as described above, the total number of measurement lines may be less than 12 lines in each of the vertical and horizontal directions. In addition, in this case, since four measurement substrates cannot be prepared, the "average value of absolute values of differences between a maximum value and a minimum value of thicknesses" is substituted with an "absolute value of a difference between a maximum value and a minimum value of a thickness" of the one measurement substrate, and the "average thickness of the metal-clad laminate" is substituted with the "average thickness" of the one measurement substrate.

In the metal-clad laminate of the present embodiment, when the average thickness measured according to the method described above using a laser displacement meter is 400 $\mu$m or more, by setting the average value of the absolute values of the differences between the maximum value and the minimum value of the thicknesses to 20 $\mu$m or less, the variation in the amount of warpage of the semiconductor package can be effectively reduced. In addition, in the metal-clad laminate of the present embodiment, it can be said that the degree of freedom in designing the insulating resin material is high.

Further, in the metal-clad laminate of the present embodiment, in a plurality of evaluation substrates cut out from an arbitrary portion, the variation in the rate of dimensional change when heat treatment is performed after the metal foil is removed by etching is small. The variation in the rate of dimensional change of the metal-clad laminate is preferably 0.005% or less, more preferably 0.004% or less, still more preferably 0.003% or less, particularly preferably 0.002% or less, and most preferably 0.001% or less. As a method for measuring the variation in the rate of dimensional change, the following method can be adopted, but more specifically, the method described in Examples is adopted. For example, after two copper-clad laminates are prepared, two pieces of 340 mm × 250 mm are cut out (four pieces in total) as evaluation substrates, a total of four reference holes are provided in a portion 1 cm vertically and 1 cm horizontally from the four corners of the four evaluation substrates, the distance between adjacent holes is measured using a CNC image measuring machine, and the value is set as the "reference dimension". The copper foil is removed from the evaluation substrate by etching treatment. Subsequently, the evaluation substrate from which the copper foil was removed is heated at 180°C for 1 hour in the air, then allowed to cool to 25°C, and heated again at 180°C for 1 hour in the air. Thereafter, the distance between adjacent holes is measured by the same method as described above, and the value is defined as the "dimension after heating". From the respective dimensions obtained, the rate of dimensional change after heating was calculated for the four evaluation substrates based on the following formula.

Rate of dimensional change (%) = ((dimension after heating) - (reference dimension)) × 100/(reference dimension)

After calculating the rate of dimensional change of the four evaluation substrates (two data in the vertical direction and two data in the horizontal direction per substrate), the standard deviation ($\sigma$ value) is determined, and the value is taken as the variation in the rate of dimensional change.

The average thickness of the metal-clad laminate may be 400 to 2,500 $\mu$m, may be 450 to 2,000 $\mu$m, may be 500 to 1,800 $\mu$m, may be 550 to 1,600 $\mu$m, may be 700 to 1,600 $\mu$m, or may be 1,000 to 1,600 $\mu$m.

The average value of the absolute values of the differences between the maximum value and the minimum value of the thicknesses of the metal-clad laminate is 20 $\mu$m or less, preferably 16 $\mu$m or less, more preferably 12 $\mu$m or less, still more preferably 10 $\mu$m or less, and particularly preferably 6.5 $\mu$m or less, from the viewpoint of reducing the variation in the amount of warpage of the semiconductor package. In addition, the lower limit of the average value of the absolute values of the differences between the maximum value and the minimum value of the thicknesses of the metal-clad laminate is not particularly limited, but may be 1.0 $\mu$m or more. That is, the average value of the absolute values of the differences between the maximum value and the minimum value of the thicknesses of the metal-clad laminate may be 1.0 to 20 $\mu$m, may be 1.0 to 16 $\mu$m, may be 1.0 to 12 $\mu$m, may be 1.0 to 10 $\mu$m, or may be 1.0 to 6.5 $\mu$m. The average value of the absolute values of the differences between the maximum value and the minimum value of the thicknesses of the metal-clad laminate particularly preferably satisfies the above range when the average thickness of the metal-clad laminate is 700 $\mu$m or more, and further 1,000 $\mu$m or more, from the viewpoint of reducing the variation in the amount of warpage of the semiconductor package.

In addition, in the metal-clad laminate of the present embodiment, the value calculated from the following formula may be 2.0% or less, may be 1.6% or less, may be 1.2% or less, may be 1.0% or less, may be 0.7% or less, or may be 0.5% or less, from the viewpoint of reducing the variation in the rate of dimensional change of the metal-clad laminate and reducing the variation in the amount of warpage of the semiconductor package. In addition, the lower limit value of the value is not particularly limited, but may be 0.01% or more, may be 0.05% or more, may be 0.1% or more, or may be 0.15% or more. That is, the value may be 0.01 to 2.0%, may be 0.01 to 1.6%, may be 0.01 to 1.2%, may be 0.01 to 1.0%, may be 0.01 to 0.7%, may be 0.01 to 0.5%, may be 0.1 to 0.5%, or may be 0.15 to 0.5%.

(average value of absolute values of differences between maximum value and minimum value of thicknesses of metal-clad laminate) × 100/(average thickness of metal-clad laminate)

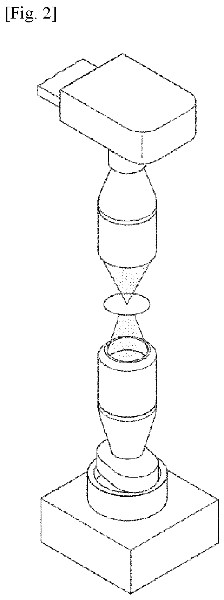

In the measurement of the thickness of the metal-clad laminate of the present embodiment, the thickness of the measurement substrate is measured by a non-contact type and sandwich type laser displacement meter (preferably a non-contact type and sandwich type laser displacement meter) as shown in Fig. 2 under the conditions of a measurement speed of 10 mm/sec, a measurement range of 300 $\mu$m in diameter, and a repeatability of 0.3 $\mu$m or less. More specifically, the measurement is performed by the method described in Examples. Here, the repeatability is a degree of variation when the measurement is repeatedly performed at a fixed point of the measurement target. As the repeatability is smaller, the degree of variation in the value due to the repeated measurement is smaller.

A laser displacement meter measures thickness by applying laser light from both sides of a measurement object and detecting the distance from the reflected light beam to each surface. As the laser displacement meter, a multicolor laser coaxial displacement meter "CL-3000" series manufactured by Keyence Corporation can be used. In the case of the laser displacement meter, it is difficult to be affected by a slight warp or the like of the metal-clad laminate itself at the time of measuring the thickness, and the measurement accuracy is high.

In the metal-clad laminate of the present embodiment, the number of plies of the prepreg may be 1 to 25, may be 2 to 20, may be 5 to 18, may be 8 to 16, or may be 10 to 14.

Examples of the metal foil included in the metal-clad laminate include a copper foil, an aluminum foil, a tin foil, a tin-lead alloy (solder) foil, and a nickel foil. A composite foil having a three-layer structure including an intermediate layer, such as nickel, nickel-phosphorus, a nickel-tin alloy, a nickel-iron alloy, lead, or a lead-tin alloy, having on both surfaces thereof a copper layer of 0.5 to 15 $\mu$m and a copper layer of 10 to 300 $\mu$m, and a composite foil having a two-layer structure including aluminum and a copper foil may also be used. The metal foil is preferably a copper foil, the composite foil having a three-layer structure, or the composite foil having a two-layer structure, and more preferably a copper foil. In a case where the metal foil is a copper foil, the metal-clad laminate is referred to as a copper-clad laminate.

The thickness of the metal foil may be a thickness that has been ordinarily used in laminates. The thickness of the metal foil is preferably 1 to 200 $\mu$m, more preferably 3 to 100 $\mu$m, still more preferably 5 to 50 $\mu$m, particularly preferably 5 to 25 $\mu$m, and most preferably 7 to 18 $\mu$m.

(Method for Producing Metal-Clad Laminate)

The metal-clad laminate of the present embodiment can be produced by disposing metal foils on both surfaces of one ply of a prepreg, or on both surfaces of a prepreg laminate including one or more plies of a prepreg, and then press-molding. Specific examples of the method of press-molding include a method of press-molding under conditions of a vacuum degree of preferably 300 kPa or less, and more preferably 100 kPa or less, a temperature of preferably 130 to 350°C, more preferably 150 to 300°C, and still more preferably 170 to 250°C, and a pressure of preferably 0.5 to 10 MPa, and more preferably 1 to 5 MPa, with a vacuum press.

The method for producing the metal-clad laminate of the present embodiment, that is, the metal-clad laminate in which the average thickness measured according to the above-described method is 400 $\mu$m or more and the average value of the absolute values of the differences between the maximum value and the minimum value of the thicknesses is 20 $\mu$m or less is not particularly limited, but the metal-clad laminate can also be produced by using, for example, a prepreg described later.

(Prepreg)

The prepreg is not particularly limited, and examples thereof include a prepreg containing a fiber substrate having a thickness of 40 $\mu$m or more and a thermosetting resin composition, in which the prepreg has an impregnated region and a non-impregnated region with the thermosetting resin composition in the fiber substrate, and the prepreg has a surface waviness (Wa) of 5.0 $\mu$m or less. With the prepreg, the metal-clad laminate of the present embodiment can be produced. It should be noted that the fact that the prepreg has an impregnated region and a non-impregnated region with the thermosetting resin composition in the fiber substrate only relates to the prepreg, that is, the prepreg in a B-stage state, and does not relate to a cured product of the prepreg.

The surface waviness (Wa) is an arithmetic average height (Wa) that can be obtained from a waviness curve in accordance with ISO 4287 (1997). JIS B0601 (2001) may be used instead of ISO 4287 (1997). The surface waviness (Wa) can be measured in the following manner.

The shape measurement is automatically performed with the observation application using a shape analysis laser microscope "VK-X100" (manufactured by Keyence Corporation) to obtain a waviness curve in accordance with ISO 4287 (1997) or JIS B0601 (2001). The resulting waviness curve is analyzed for the surface roughness with the analysis application thereof to calculate the surface waviness (Wa). The waviness curve herein is a curve obtained by removing a wavelength of less than 80 $\mu$m from the cross sectional curve by applying a phase compensation high-pass filter $\lambda$c ($\lambda$c = 80 $\mu$m) on the cross sectional curve. The analysis region is 1,000 $\mu$m $\times$ 1,000 $\mu$m.

Unless otherwise specified, the surface waviness (Wa) of the prepreg is the surface waviness of both surfaces of the prepreg, and the "surface" refers to a surface to be overlapped or a surface opposite thereto when a plurality of prepregs are laminated to prepare a metal-clad laminate.

The prepreg has a surface waviness (Wa) of 5.0 $\mu$m or less irrespective of the use of the "fiber substrate having a thickness of 40 $\mu$m or more", which has a larger surface waviness than a thin fiber substrate. This is realized by the method of "intentionally providing a non-impregnated region with the thermosetting resin composition in the fiber substrate of the prepreg". The method is generally difficult to employ in consideration of the ordinary technical common sense in the production of the prepreg that voids are suppressed from occurring by increasing the impregnation rate of the thermosetting resin composition in the fiber substrate as much as possible. Then, it was found that the metal-clad laminate of the present embodiment can be produced by using the prepreg.

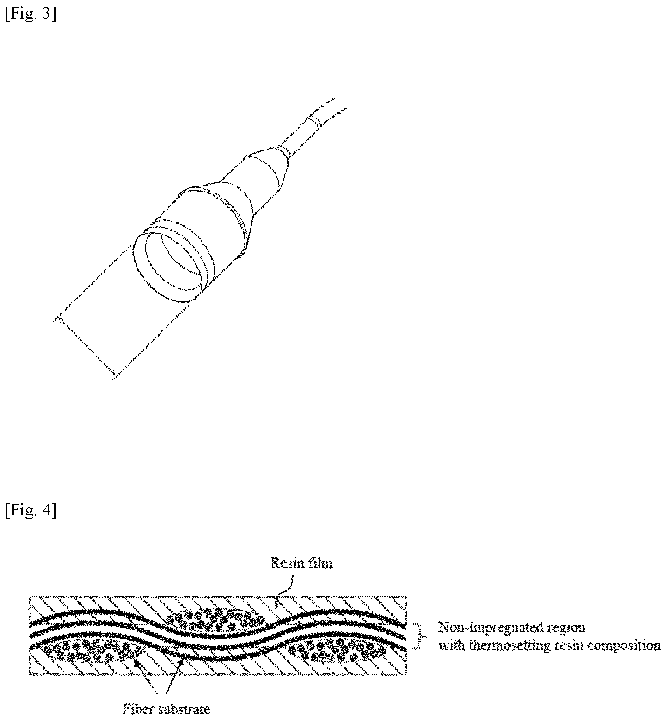

The mechanism by which the metal-clad laminate of the present embodiment can be produced by the prepreg is not clear, but is considered as follows. For example, as shown in Fig. 4, in impregnating a fiber substrate with a resin film, the region that is not impregnated with the thermosetting resin composition is intentionally provided in the fiber substrate, and thereby the layer of the thermosetting resin composition (which may be hereinafter abbreviated as a resin layer) in the vicinity of the surface is allowed to exist not along the waviness of the glass cloth. As a result, the large waviness of the fiber substrate having a thickness of 40 $\mu$m or more become hard to reflect on the surface of the prepreg, and thereby the surface waviness (Wa) of the prepreg is allowed to be 5.0 $\mu$m or less. Then, by press-molding using the prepreg having a surface waviness (Wa) of 5.0 $\mu$m or less, it is possible to produce the metal-clad laminate of the present embodiment in which the variation in the thickness of the metal-clad laminate is suppressed due to the small surface waviness (Wa) of the prepreg.

In the prepreg, while the non-impregnated region with the thermosetting resin composition is provided in the fiber substrate, voids in the metal-clad laminate can be sufficiently suppressed from occurring by allowing the thermosetting resin composition to flow in the thickness direction and run into the non-impregnated region in press-molding in the production of the metal-clad laminate.

From the above viewpoint, the surface waviness (Wa) of the prepreg is preferably 5.0 $\mu$m or less, more preferably 3.0 $\mu$m or less, and still more preferably 1.0 $\mu$m or less. The lower limit value of the surface waviness (Wa) of the prepreg is not particularly limited, and may be 0.01 $\mu$m or more, may be 0.1 $\mu$m or more, or may be 0.2 $\mu$m or more. Accordingly, the surface waviness (Wa) of the prepreg may be 0.01 to 5.0 $\mu$m, may be 0.1 to 3.0 $\mu$m, or may be 0.2 to 1.0 $\mu$m.

(Existence of Non-impregnated Region with Thermosetting Resin Composition in Fiber Substrate)

The prepreg has the impregnated region and the non-impregnated region with the thermosetting resin composition in the fiber substrate as described above, and has the particular feature that the non-impregnated region exists. The existence of the non-impregnated region can be confirmed by determining the existing ratio of the impregnated region with the thermosetting resin composition in the fiber substrate. Specifically, the existing ratio of the impregnated region that does not reach 100% means the existence of the non-impregnated region.

Examples of the method of determining the existing ratio of the impregnated region with the thermosetting resin composition in the fiber substrate include the following calculation method. From the viewpoint of the thickness accuracy of the metal-clad laminate, the existing ratio of the impregnated region obtained based on the following calculation method is not particularly limited, and may be 25 to 98%, may be 30 to 98%, may be 35 to 97%, may be 40 to 95%, may be 35 to 90%, may be 40 to 85%, may be 40 to 75%, may be 45 to 98%, may be 50 to 98%, may be 60 to 97%, may be 65 to 97%, or may be 75 to 97%. In a case where the existing ratio is 98% or less, there is a tendency of increasing the effect of improving the thickness accuracy of the metal-clad laminate, and in particular, in a case where the existing ratio is 95% or less, the tendency is further enhanced. In addition, in a case where the existing ratio is 25% or more, powder falling of the thermosetting resin composition from the prepreg is suppressed, and thus a secondary effect of good handleability tends to be obtained.

- Calculation Method -

The surface of the prepreg is observed with an optical microscope at a magnification of 50 times to obtain a surface observation image. As the observation conditions, the observation conditions described in Examples are adopted in detail from the viewpoint of imaging with suitable brightness.

The obtained surface observation image is converted to monochrome mode with image editing software, and saved in BMP (Microsoft Windows Bitmap Image) format. Subsequently, the surface observation image in monochrome mode saved in BMP format is converted to RGB (red, green, blue) values pixel by pixel with image converting software, and then saved in CSV (comma-separated values) format. The RGB data saved in CSV format is pasted on Microsoft Excel (available from Microsoft Corporation), and calculated for areas of a black part (RGB value = 255) and a white part (RGB value = 0). An area ratio of the black part with respect to the total of the black part and the white part is calculated from the resulting values. The area ratio of the black part thus obtained is designated as the existing ratio of the impregnated region.

As the image editing software, for example, "Microsoft Paint" (available from Microsoft Corporation) can be used. In addition, as the image conversion software, for example, "bmp2csv", which is a free software, can be used.

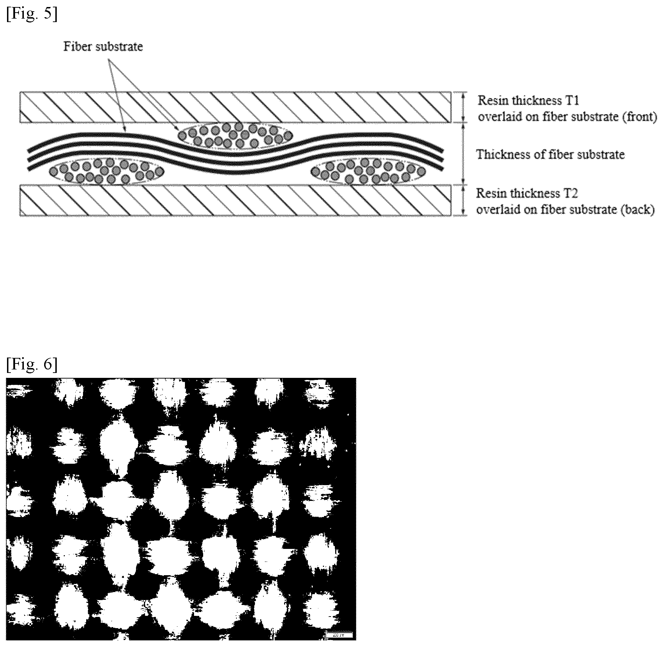

In the observation, in converting the surface observation image imaged under suitable brightness to monochrome mode, the surface having the non-impregnated region with the thermosetting resin composition existing under the observation surface is a gap portion and is easy to reflect light, thus, is expressed in white, and the other surface is expressed in black. The surface observation image is preferably imaged with an exposure time in imaging the surface regulated to a range of 60 to 100 ms since the imaging can be performed under suitable brightness capable of sufficiently representing the impregnated region and the non-impregnated region. On the surface observation image of the prepreg, the "region having no glass cloth in the resin layer", the "region having the glass cloth sufficiently impregnated with the thermosetting resin composition", and the "region having the glass cloth insufficiently impregnated with the thermosetting resin composition" exist in descending order of the color strength. In the present embodiment, the "region having no glass cloth in the resin layer" is also encompassed in the impregnated region. In a case where the surface observation image is too bright, in the surface observation image in monochrome mode, not only the region having the glass cloth insufficiently impregnated with the resin, but also the region having the glass cloth sufficiently impregnated with resin tend to be white, and in a case where the image is further brighter, there is a tendency that the entire surface observation image in monochrome mode becomes white. On the other hand, in a case where the surface observation image is too dark, there is a tendency that the entire surface observation image in monochrome mode becomes black, and the existence of the non-impregnated region is difficult to represent. Accordingly, the imaging is preferably performed under suitable brightness. As an example of a surface observation image imaged under suitable brightness converted to monochrome mode, the surface observation image converted to monochrome mode obtained in Example 1 is shown in Fig. 6.

The area ratio of the white part with respect to the total of the black part and the white part can be easily calculated by using the COUNTIF function of Microsoft Excel (available from Microsoft Corporation).

(Relationship of Thicknesses of Resin protruding from Fiber Substrate on Front and Back Surfaces of Prepreg)

In the prepreg, while not particularly limited, the difference between the thicknesses of the resin protruding from the fiber substrate on both surfaces of the prepreg is preferably 0 to 10 $\mu$m, and thereby the warpage of the prepreg itself can be suppressed, and the amount of warpage of the metal-clad laminate can be reduced. In the present disclosure, the thickness of the thermosetting resin composition protruding from the fiber substrate on each of front and back surfaces of the prepreg may be referred to as a "resin thickness", and the difference between the resin thickness on the front surface of the prepreg and the resin thickness on the back surface of the prepreg may be referred to as a "difference in resin thickness".

From the viewpoint of reducing the amount of warpage of the metal-clad laminate, the difference in resin thickness is more preferably 0 to 7 $\mu$m, still more preferably 0 to 5.5 $\mu$m, particularly preferably 0 to 3.5 $\mu$m, and most preferably 0 to 2.5 $\mu$m. The lower limit value of the difference in resin thickness may be 0.1 $\mu$m, may be 0.3 $\mu$m, may be 0.5 $\mu$m, or may be 0.8 $\mu$m.

As shown in Fig. 5, the resin thickness is the shortest distance from the resin end part to the glass cloth on the front or back of the prepreg in the observation image when the cross section of the prepreg is observed with a metallurgical microscope. In addition, in Fig. 5, the thermosetting resin composition with which the fiber substrate is impregnated is not shown for convenience.

It is presumed that by reducing the difference in resin thickness protruding from the fiber substrate as described above, the difference in the amount of thermal expansion between the front and back surfaces of the prepreg during press-molding is reduced, and therefore, when a metal-clad laminate is obtained, it tends to be difficult to warp. Reducing the amount of warpage of the metal-clad laminate contributes to improving the connection reliability of the printed wiring board and the semiconductor package.

(Fiber Substrate)

The fiber substrate having a thickness of 40 $\mu$m or more contained in the prepreg may be a known one used in various laminates for an electric insulating material. Examples of the material of the fiber substrate include natural fibers, such as paper and cotton linters; inorganic fibers, such as glass fibers and asbestos; organic fibers, such as aramid, polyimide, polyvinyl alcohol, polyester, tetrafluoroethylene, and acrylic; and mixtures thereof. Among these, inorganic fibers are preferable, and glass fibers are more preferable, from the viewpoint of the flame retardancy. Further, examples of the glass fibers include glass cloths using E glass, C glass, D glass, S glass, or the like; glass cloths obtained by bonding short fibers with an organic binder; and those obtained by mixing glass fibers and cellulose fibers. Among these, a glass cloth using E glass is preferable as the glass fibers.

The shape of the fiber substrate is not particularly limited, and may be a woven fabric, a nonwoven fabric, a roving, a chopped strand mat, a surfacing mat, or the like. Among these, in the case of a woven fabric, the effect of improving the thickness accuracy of the metal-clad laminate tends to be more remarkable. That is, it is more preferable to use a glass woven fabric (also referred to as a glass cloth) as the fiber substrate. The material and the shape thereof may be appropriately selected depending on the purpose and the capabilities of the target molded article. One kind of the fiber substrate may be used alone, or two or more kinds of materials and two or more kinds of shapes may be used in combination depending on necessity.

The fiber substrate may be a fiber substrate formed of one layer, or may be a fiber substrate including multiple layers. The fiber substrate formed of one layer means a fiber substrate that is formed only of entangled fibers, and the case where a fiber substrate having no entanglement exists is classified into the fiber substrate including multiple layers. The materials and the shapes of the two or more layers of the fiber substrate each may be the same as or different from each other.

(Thickness of Fiber Substrate)

The thickness of the fiber substrate contained in the prepreg (see Fig. 5) is set to "40 $\mu$m or more", which has been found by the study of the present inventors to "tend to deteriorate the thickness accuracy of the metal-clad laminate". The thickness of the fiber substrate may be 40 to 120 $\mu$m, may be 45 to 120 $\mu$m, may be 50 to 120 $\mu$m, may be 55 to 120 $\mu$m, may be 60 to 120 $\mu$m, may be 70 to 120 $\mu$m, may be 80 to 110 $\mu$m, or may be 90 to 110 $\mu$m. The thickness of the fiber substrate is preferably less than 100 $\mu$m, may be 40 $\mu$m or more and less than 100 $\mu$m, may be 40 to 97 $\mu$m, may be 50 to 97 $\mu$m, may be 60 to 97 $\mu$m, may be 70 to 97 $\mu$m, or may be 80 to 95 $\mu$m, from the viewpoint that the impregnation properties of the thermosetting resin composition into the fiber substrate are improved and the heat resistance and insulation reliability of the cured product of the prepreg tend to be more favorable. Since the surface waviness of the fiber substrate itself tends to increase as the thickness of the fiber substrate increases, the thickness accuracy of the metal-clad laminate is generally decreased. However, by using the prepreg, the surface waviness (Wa) of the prepreg is suppressed to be small even when the thickness of the fiber substrate is large as described above, and as a result, the thickness accuracy of the metal-clad laminate is increased, and the metal-clad laminate of the present embodiment is easily produced.

In the present disclosure, the thickness of the fiber substrate is the thickness of the position shown in Fig. 5, and is an average value of values obtained by measuring arbitrary five portions of the fiber substrate with a micrometer.

As described above, the metal-clad laminate of the present embodiment can be produced using a plurality of plies of the prepreg, and may include three or more plies of the fiber substrate. As described above, since the metal-clad laminate of the present embodiment has high thickness accuracy, the surface of the cured product of the prepreg does not need to be subjected to a smoothing treatment such as polishing and roll pressing, and the productivity is excellent. Therefore, in the metal-clad laminate including three or more plies of the fiber substrate, the fiber substrate located on the outermost side is not shaved by the smoothing treatment, and the thickness of the fiber substrate located on the outermost side on at least one surface side of the metal-clad laminate is in a range of 0.6 to 1.3 times, preferably in a range of 0.7 to 1.3 times, more preferably in a range of 0.8 to 1.2 times, and still more preferably in a range of 0.9 to 1.1 times the thickness of the fiber substrate adjacent to the fiber substrate. It is preferable that the thickness of the fiber substrate located on the outermost side on both surface sides of the metal-clad laminate is within the above range with respect to the thickness of the adjacent fiber substrate.

(Thickness of Prepreg)

The thickness of the prepreg can be appropriately determined depending on the thickness of the fiber substrate and the like, may be 50 to 300 $\mu$m, may be 50 to 250 $\mu$m, may be 55 to 200 $\mu$m, may be 60 to 180 $\mu$m, may be 70 to 150 $\mu$m, or may be 80 to 130 $\mu$m. The thickness of the prepreg herein means the thickness of one ply of the prepreg. In a case where the thickness of the prepreg is the lower limit value or more, there is a tendency that the effect of reducing the surface waviness by the present embodiment is enhanced. In a case where the thickness of the prepreg is the upper limit value or less, there is a tendency that voids can be suppressed from occurring after the production of the laminate in the present embodiment.

In the present disclosure, the thickness of the prepreg is an average value of values obtained by measuring arbitrary five portions of the prepreg with a digimatic indicator.

<Thermosetting Resin Composition>

The prepreg is obtained by impregnating a fiber substrate having a thickness of 40 μm or more with a thermosetting resin composition, followed by semi-curing (B-staging). Here, in the present disclosure, B-staging is to bring into a B-stage state as defined in JIS K6900 (1994).

The thermosetting resin composition contains at least a thermosetting resin. The components contained in the thermosetting resin composition are not particularly limited, and preferably include, in addition to the thermosetting resin, at least one selected from the group consisting of a curing agent, a curing accelerator, an inorganic filler, an organic filler, a coupling agent, a leveling agent, an antioxidant, a flame retardant, a flame retardant aid, a thixotropy imparting agent, a thickener, a flexible material, a surfactant, and a photopolymerization initiator.

Hereinafter, each component contained in the thermosetting resin composition will be briefly described.

(Thermosetting Resin)

Examples of the thermosetting resin include an epoxy resin, a polyimide resin, a maleimide resin, a modified maleimide resin, a phenol resin, a polyphenylene ether resin, a bismaleimide-triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Examples of the modified maleimide resin include a reaction product of a maleimide compound having at least two N-substituted maleimide groups and at least one kind of a compound selected from the group consisting of a monoamine compound and a diamine compound. Here, the maleimide resin does not include the modified maleimide resin. The thermosetting resin is not particularly limited to these resins, and known thermosetting resins may be used. One kind of the thermosetting resin may be used alone, or two or more kinds thereof may be used in combination.

Among these, from the viewpoint of moldability and electrical insulating properties, as the thermosetting resin, at least one selected from the group consisting of an epoxy resin, a polyimide resin, a maleimide resin, a modified maleimide resin, a cyanate resin, a polyphenylene ether resin, and a bismaleimide-triazine resin is preferably contained, at least one selected from the group consisting of an epoxy resin, a polyimide resin, a maleimide resin, a modified maleimide resin, a cyanate resin, and a polyphenylene ether resin is more preferably contained, and at least one selected from the group consisting of an epoxy resin, a maleimide resin, and a modified maleimide resin is still more preferably contained.

The epoxy resin is preferably an epoxy resin having two or more epoxy groups in one molecule. The epoxy resin herein is classified into a glycidyl ether type epoxy resin, a glycidyl amine type epoxy resin, a glycidyl ester type epoxy resin, and the like. Among these, a glycidyl ether type epoxy resin is preferable.

The epoxy resin is classified into various epoxy resins depending on the difference in main skeleton. For example, the aforementioned types of epoxy resins each are further classified into a bisphenol type epoxy resin, an alicyclic epoxy resin, an aliphatic linear epoxy resin, a novolac type epoxy resin, a stilbene type epoxy resin, a naphthalene skeleton-containing epoxy resin, a biphenyl type epoxy resin, a xylylene type epoxy resin, a dihydroanthracene type epoxy resin, and the like. One kind of the epoxy resin may be used alone, or two or more kinds thereof may be used in combination from the viewpoint of the insulation reliability and the heat resistance.

The epoxy resin may be a novolac type epoxy resin or may be a phenol-novolac type epoxy resin.

In the thermosetting resin composition, the content of the thermosetting resin is preferably 10 to 100% by mass, more preferably 20 to 95% by mass, still more preferably 30 to 95% by mass, particularly preferably 30 to 90% by mass, most preferably 30 to 70% by mass, and may be 35 to 55% by mass, with respect to the total amount of the solid content.

(Curing Agent)

In a case where the thermosetting resin contains an epoxy resin, examples of the curing agent include a curing agent for an epoxy resin, such as a phenol-based curing agent, a cyanate ester-based curing agent, an acid anhydride-based curing agent, an amine-based curing agent, and an active ester group-containing compound. In a case where the thermosetting resin contains a resin other than an epoxy resin, a known curing agent for that thermosetting resin may be used. One kind of the curing agent may be used alone, or two or more kinds thereof may be used in combination.

Preferred examples of the phenol-based curing agent include a cresol-novolac type phenol resin, a biphenyl-aralkyl type phenol resin, a phenol-novolac type phenol resin, a naphthylene ether type phenol resin, and a triazine skeleton-containing phenol resin, while not particularly limited.

Examples of the cyanate ester-based curing agent include bisphenol A dicyanate and polyphenyl cyanate (oligo(3-methylene-1,5-phenylenecyanate)), while not particularly limited.

Examples of the acid anhydride-based curing agent include phthalic anhydride, tetrahydrophthalic anhydride, trimellitic anhydride, and pyromellitic anhydride, while not particularly limited.

Examples of the amine-based curing agent include an aliphatic amine, such as triethylenetetramine and tetraethylenepentamine, and an aromatic amine, such as 4,4'-diaminodiphenylmethane, while not particularly limited.

A urea resin and the like may also be used as the curing agent.

In a case where the thermosetting resin composition contains the curing agent, the content thereof is preferably 20 to 200 parts by mass, more preferably 20 to 150 parts by mass, and still more preferably 30 to 100 parts by mass with respect to 100 parts by mass of the thermosetting resin.

In a case where the thermosetting resin composition contains the curing agent, the content thereof may also be expressed in terms of functional group equivalent. Specifically, the content of the curing agent preferably satisfies the expression, ((mass of thermosetting resin)/(functional group equivalent)) $\approx$ ((mass of curing agent)/(functional group equivalent capable of reacting to thermosetting resin)) $\times$ constant C. The constant C varies depending on the kind of the functional group of the curing agent, and is preferably 0.8 to 1.2 for the case where the functional group is a phenolic hydroxy group, preferably 0.2 to 0.4 for the case where the functional group is an amino group, and preferably 0.3 to 0.6 for the case where the functional group is an active ester group.

In a case where the thermosetting resin contains an epoxy resin, the expression is ((mass of epoxy resin)/(epoxy group equivalent)) $\approx$ ((mass of curing agent)/(functional group equivalent capable of reacting to epoxy group)) $\times$ constant C.

(Curing Accelerator)

The curing accelerator used may be an ordinary curing accelerator having been used for curing the thermosetting resin. For example, in a case where the thermosetting resin contains an epoxy resin, examples of the curing accelerator include an imidazole compound and a derivative thereof, a phosphorus compound, a tertiary amine compound, and a quaternary ammonium compound. From the viewpoint of accelerating the curing reaction, an imidazole compound and a derivative thereof are preferable.

Specific examples of the imidazole compound and a derivative thereof include an imidazole compound, such as 2-methylimidazole, 2-ethylimidazole, 2-undecylimidazole, 2-phenylimidazole, 1,2-dimethylimidazole, and 2,4-diamino-6-[2'-methylimidazolyl-(1')]ethyl-s-triazine; a salt of the imidazole compound and trimellitic acid, such as 1-cyanoethyl-2-phenylimidazolium trimellitate; a salt of the imidazole compound and isocyanuric acid; and a salt of the imidazole compound and hydrobromic acid. One kind of the imidazole compound and a derivative thereof may be used alone, or two or more kinds thereof may be used in combination.

The curing accelerator may be an imidazole compound and a derivative thereof, or may be an imidazole compound.

In a case where the thermosetting resin composition contains the curing accelerator, the content thereof is preferably 0.1 to 20 parts by mass, and more preferably 0.1 to 10 parts by mass with respect to 100 parts by mass of the thermosetting resin.

(Inorganic Filler)

An inorganic filler can reduce the thermal expansion coefficient and can improve the coating film strength.

Examples of the inorganic filler include silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride, boron nitride, clay (such as baked clay), a molybdic acid compound such as zinc molybdate, glass short fibers, glass powder, and hollow glass beads. Preferred examples of the glass as the material of glass short fibers, glass powder, and hollow glass beads include E glass, T glass, and D glass. One kind of the inorganic filler may be used alone, or two or more kinds thereof may be used in combination. Among these, from the viewpoint of reducing the thermal expansion coefficient and reducing the relative permittivity and the dielectric loss tangent, silica and alumina are preferable, and from the viewpoint of the heat resistance, aluminum hydroxide is preferable. As the inorganic filler, the combined use of silica and aluminum hydroxide is more preferable.

Examples of the silica include precipitated silica having a high water content produced by the wet method and dry method silica containing substantially no combined water or the like produced by the dry method. Examples of the dry method silica include crushed silica, fumed silica, and fused silica (molten spherical silica), based on the difference in production method.

The inorganic filler may be subjected to a surface treatment with a surface treating agent, such as a silane coupling agent, for improving the moisture resistance, and may be subjected to a hydrophobizing treatment for improving the dispersibility.

In a case where the thermosetting resin composition contains the inorganic filler, the content thereof is preferably 0.1 to 65% by volume with respect to the total amount of the solid content while varying depending on the purpose of the addition. In a case where the content thereof is 0.1% by volume or more, the coefficient of thermal expansion tends to be reduced. On the other hand, by suppressing the content to 65% by volume or less, there is a tendency that the viscosity in blending the resin component does not become too high, and the deterioration in workability can be easily suppressed from occurring. From the same viewpoint, the content of the inorganic filler is more preferably 10 to 60% by volume, still more preferably 15 to 55% by volume, and particularly preferably 30 to 55% by volume with respect to the total amount of the solid content.

(Coupling Agent)

By containing the coupling agent, there is an effect of improving the dispersibility of the inorganic filler and the organic filler, and improving the adhesion to the reinforcing substrate and the metal foil. One kind of the coupling agent may be used alone, or two or more kinds thereof may be used in combination.
The coupling agent may be a titanate coupling agent, a silane coupling agent, or the like.

(Organic Solvent)

From the viewpoint of facilitating the handling, the thermosetting resin composition may further contain an organic solvent. In the present disclosure, the thermosetting resin composition that contains an organic solvent may be referred to as a resin varnish.
Examples of the organic solvent include an alcohol-based solvent, such as methanol, ethanol, methyl cellosolve, butyl cellosolve, and propylene glycol monomethyl ether; a ketone-based solvent, such as acetone, methyl ethyl ketone, methyl isobutyl ketone, butanone, cyclohexanone, and 4-methyl-2-pentanone; an ester-based solvent, such as ethyl acetate, butyl acetate, propylene glycol monomethyl ether acetate, and $\gamma$-butyrolactone; an ether-based solvent, such as tetrahydrofuran; an aromatic-based solvent, such as toluene, xylene, and mesitylene; a nitrogen atom-containing solvent, such as N,N-dimethylformamide, N,N-dimethylacetamide, and N-methylpyrrolidone; and a sulfur atom-containing solvent, such as dimethylsulfoxide, while not particularly limited.
One kind of the organic solvent may be used alone, or two or more kinds thereof may be used in combination.
From the viewpoint of ease of application, for example, the content of the organic solvent may be adjusted so that the solid concentration of the thermosetting resin composition is preferably 20 to 85% by mass, and more preferably 40 to 80% by mass.
The resin varnish may be prepared using an organic solvent. However, since the prepreg is obtained through a step of preparing a resin film and then impregnating a fiber substrate with the resin film, the organic solvent is volatilized at the stage of preparing the resin film. As a result, the prepreg contains substantially no organic solvent remaining, and specifically the content thereof may be 5% by mass or less.
The method of preparing the thermosetting resin composition is not particularly limited, and an ordinarily known preparing method may be used.
For example, a resin varnish can be prepared by adding a thermosetting resin and, if necessary, other components to the organic solvent, followed by mixing and stirring using various mixers. Examples of the mixer include mixers of an ultrasonic dispersion type, a highpressure collision dispersion type, a high-speed rotation dispersion type, a bead mill type, a high-speed shear dispersion type, and a planetary centrifugal dispersion type.

(Method for Producing Prepreg)

The method for producing the prepreg is preferably the following production method from the viewpoint of improving the thickness accuracy of the metal-clad laminate.
Specifically, the method is preferably a method for producing a prepreg having a surface waviness (Wa) of 5.0 $\mu$m or less, including impregnating a fiber substrate having a thickness of 40 $\mu$m or more with a film of a thermosetting resin composition through lamination, the method for producing a prepreg including providing in the fiber substrate an impregnated region and a non-impregnated region with the thermosetting resin composition.
In the production method, a film of a thermosetting resin composition (which may be hereinafter referred to as a "resin film") is used.
In the method for producing a prepreg described above, the fiber substrate, the thermosetting resin composition, and the surface waviness (Wa) are explained as described above.
The resin film can be produced by forming a layer of a thermosetting resin composition (hereinafter, sometimes abbreviated as a resin layer) on one surface of a support. The resin layer can be formed, for example, by coating the resin varnish on one surface of a support and then drying. The film formed in this manner may be referred to as a resin film with a support.
The method of coating the resin varnish is not particularly limited, and can be performed, for example, by using a known coating device, such as a comma coater, a bar coater, a kiss coater, a roll coater, a gravure coater, and a die coater. The coating device is preferably selected appropriately in consideration of the thickness of the resin layer.

The drying temperature and the drying time may vary depending on the amount of the organic solvent used and the boiling point of the organic solvent, and for example, in the case of the resin varnish containing 30 to 70% by mass of the organic solvent, the resin film can be favorably formed by drying at 50 to 160°C for 1 to 8 minutes.

(Thickness of Resin Film)

The thickness of the resin film may be appropriately determined depending on the thickness of the prepreg and the like. For example, in a case where the thickness of the fiber substrate is in a range of 40 to 120 $\mu$m, the thickness of the resin film is preferably 10 to 100 $\mu$m, more preferably 15 to 70 $\mu$m, and still more preferably 20 to 50 $\mu$m. In the present dislosure, the thickness of the resin film is a value that is measured in the following manner. First, the total thickness of the film with the resin after coating is measured at arbitrary five portions with a digimatic indicator. At each of the measured portions, after removing the resin layer with an adhesive tape, the thickness of the support is measured with a digimatic indicator, and the values obtained by subtracting the thickness of the support from the total thickness are averaged.

In a case where the thickness of the resin film is the lower limit value or more, there is a tendency that the amount of the resin for impregnating a thick glass cloth having a thickness of 40 $\mu$m or more can be sufficiently secured. In a case where the thickness of the resin film is the upper limit value or less, there is a tendency that the resin film can be easily produced.

(Support)

Examples of the support include an organic film such as polyethylene terephthalate (PET), biaxially oriented polypropylene (OPP), polyethylene, polyvinyl fluoride, and polyimide; and a metal foil of a metal such as copper and aluminum or an alloy. The support may be subjected to a release treatment with a release agent.

The thickness of the support is not particularly limited, and is preferably 10 to 200 $\mu$m, more preferably 20 to 100 $\mu$m, and still more preferably 30 to 70 $\mu$m, from the viewpoint of the handleability in coating the thermosetting resin composition and the economic efficiency.

A commercially available product may also be used as the support.

(Method of Impregnating Fiber Substrate with Resin Film)

Next, a method of impregnating the fiber substrate with the resin film through lamination will be described.

First, the resin film with the support is disposed on at least one surface of the fiber substrate in such a manner that the resin film is brought into contact with the fiber substrate. Thereafter, the resin film with the support thus disposed and the fiber substrate are heated and pressurized, and thereby the fiber substrate is impregnated with the resin film. At this time, the non-impregnated region with the thermosetting resin composition is provided in the fiber substrate. In this way, a prepreg with a support is obtained.

The heating and pressurizing herein is preferably performed through lamination. Examples of the method of the lamination include (a) roll lamination and (b) a lamination method under reduced pressure, such as a vacuum lamination method.

The condition of (a) the roll lamination is not particularly limited, but from the viewpoint of providing the non-impregnated region with the thermosetting resin composition, the heating temperature is preferably 80 to 180°C, and the pressurizing pressure (linear pressure) is preferably 0.05 to 1.0 MPa/m.

The condition of (b) the lamination method under reduced pressure is not particularly limited, but from the viewpoint of providing the non-impregnated region with the thermosetting resin composition, the heating temperature is preferably 50 to 170°C, and more preferably 100 to 160°C, the vacuum time is preferably 10 to 120 seconds, and more preferably 20 to 80 seconds, the pressurizing time is preferably 10 to 120 seconds, and more preferably 20 to 80 seconds, and the pressurizing pressure is preferably 0.05 to 1.0 MPa, and more preferably 0.1 to 0.6 MPa.

(Method of Providing Non-impregnated Region)

Examples of the method of providing the non-impregnated region with the thermosetting resin composition in the fiber substrate include a method of regulating the condition in heating and pressurizing the resin film with the support and the fiber substrate, while not particularly limited. Specific examples thereof include a method of regulating the lamination condition.

Here, in a case where the same lamination condition is applied to the case of a thin fiber substrate and the case of a thick fiber substrate, the case of a thick fiber substrate has a tendency that the fiber substrate is more difficult to impregnate with the resin film. Therefore, even in a case where the lamination condition in the present embodiment is equivalent to the condition in laminating the resin film with the ordinary thin fiber substrate, the non-impregnated region with the thermosetting resin composition can be provided in the fiber substrate in the present embodiment.

Specific examples of the method of regulating the condition in heating and pressurizing include the following method, while not particularly limited. First, a prepreg is produced under the prescribed heating and pressurizing condition, and thereafter the existing ratio of the impregnated region with the thermosetting resin composition in the fiber substrate is obtained based on the calculation method described above. As a result, in a case where the impregnated region is 100%, i.e., there is no non-impregnated region, a prepreg is again produced by decreasing the heating temperature or decreasing the pressurizing pressure, or by decreasing both the heating temperature and the pressurizing pressure, and the existing ratio of the impregnated region is obtained again. The procedure is repeated depending on necessity, and thereby the condition for producing the prepreg having the non-impregnated region can be easily comprehended.

In a case where the existing ratio of the non-impregnated region is to be regulated lower, a prepreg is again produced by increasing the heating temperature or increasing the pressurizing pressure, or by increasing both the heating temperature and the pressurizing pressure.

In a case where the lamination is performed under reduced pressure, the existing ratio of the non-impregnated region can also be regulated by regulating the vacuum degree.

It is preferred that one or more plies of the resin film is disposed and laminated on each of both surfaces of the fiber substrate. The number of plies of the resin film is preferably one or two, and more preferably one, per one surface of the fiber substrate.

After impregnating the fiber substrate with the resin film, the resulting product is cooled depending on necessity, and then the support is released therefrom to produce the prepreg having a surface waviness (Wa) of 5.0 $\mu$m or less.

[Printed Wiring Board]

The present disclosure also provides a printed wiring board including the metal-clad laminate of the present embodiment. The printed wiring board of the present embodiment is a printed wiring board obtained by forming a wiring pattern on the metal-clad laminate of the present embodiment. That is, the printed wiring board of the present embodiment does not need to include the metal-clad laminate of the present embodiment as it is, and the wiring pattern may be formed on the metal-clad laminate, or the upper and lower portions of the insulating resin layer (the cured product of one or more plies of prepreg) may be in a state of conduction through the via holes opened in the metal-clad laminate.

Examples of the method of forming a wiring pattern include known processes, such as a subtractive process, a full additive process, a semi-additive process (SAP), and a modified semi-additive process (m-SAP).

A multilayer printed wiring board can also be produced by performing a multilayer adhesion process as necessary.

In the printed wiring board of the present embodiment, the prepreg and the resin film are C-staged. In the present disclosure, C-staging is to bring into a C-stage state as defined in JIS K6900 (1994).

[Semiconductor Package]

The present disclosure also provides a semiconductor package including the printed wiring board of the present embodiment and a semiconductor element. The semiconductor package of the present embodiment can be produced, for example, by mounting a semiconductor element such as a semiconductor chip or a memory at a predetermined position of the printed wiring board of the present embodiment by a known method, and then sealing the semiconductor element with a sealing resin or the like.

Examples

Next, the present embodiment will be described in more detail with reference to the following Examples, but these Examples do not limit the present embodiment.

The prepreg, the copper-clad laminate, and the semiconductor package produced in each example were measured and evaluated according to the following methods.

[1. Surface Waviness (Wa)]

The shape of the prepreg produced in each example was automatically measured by an observation application using a shape analysis laser microscope "VK-X100" (manufactured by Keyence Corporation) to obtain a waviness curve in accordance with ISO 4287 (1997). The resulting waviness curve was analyzed for the surface roughness with the analysis application thereof to calculate the surface waviness (Wa) of the prepreg. The waviness curve herein is a curve obtained by removing a wavelength of less than 80 $\mu$m from the cross sectional curve by applying a phase compensation high-pass filter $\lambda$c ($\lambda$c = 80 $\mu$m) on the cross sectional curve. The analysis region was 1,000 $\mu$m $\times$ 1,000 $\mu$m.

The surface waviness (Wa) was measured for both surfaces of the prepreg, and the larger value was used.

[2. Existing Ratio of Impregnated Region]

The existing ratio (%) of the impregnated region with the thermosetting resin composition in the fiber substrate of the prepreg produced in each example was obtained based on the following calculation method.

- Calculation Method -

The surface of the prepreg was observed with an optical microscope (MX61L-F, trade name, manufactured by Olympus Corporation) under the following condition to obtain a surface observation image.

<Observation Condition>

> Magnification: 50 times
> Observation mode: dark field
> Sensibility: ISO400
> Exposure time in surface imaging: 60 to 100 ms
> Brightness of observation environment: two 35 W fluorescent light tubes disposed 2 m above observation stage

The resulting surface observation image was converted to monochrome mode with image editing software, and saved in BMP (Microsoft Windows Bitmap Image) format. Subsequently, the surface observation image in monochrome mode saved in BMP format was converted to RGB (red, green, blue) values pixel by pixel with image converting software, and then saved in CSV (comma-separated values) format. The RGB data saved in CSV format was pasted on Microsoft Excel (available from Microsoft Corporation), and calculated for the areas of the black part (RGB value = 255) and the white part (RGB value = 0). The area ratio of the black part with respect to the total of the black part and the white part was calculated from the resulting values. The area ratio of the black part thus obtained was designated as the existing ratio (%) of the impregnated region.

Here, the surface observation image was imaged in such a manner that the impregnated region and the non-impregnated region were sufficiently reflected, with suitable brightness by regulating the exposure time in surface imaging within 60 to 100 ms as described above.

The image editing software used was Microsoft Paint (available from Microsoft Corporation). The image converting software used was "bmp2csv" which is free software.

[3. Thickness of Copper-Clad Laminate]

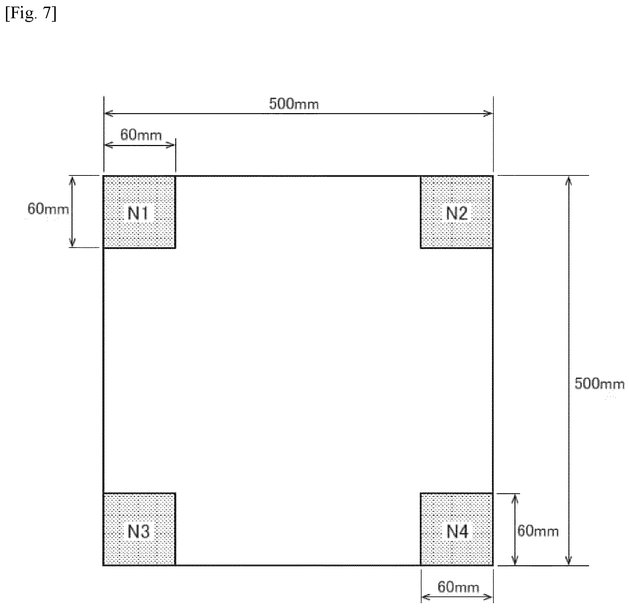

From the four corners (see Fig. 7) of the copper-clad laminate produced in each example, four measurement substrates (N1 to N4) each having a size of vertical 60 mm $\times$ horizontal 60 mm in the plane direction were cut out.

The thicknesses of the four measurement substrates were measured by a non-contact type and sandwich type laser displacement meter "CL-3000 series (sensor head: CL-L015)" (multicolor laser coaxial displacement meter, manufactured by Keyence Corporation) under the conditions of a measurement speed of 10 mm/s, a measurement range of 300 $\mu$m in diameter, a resolution of 0.003 $\mu$m, a repeatability of 0.3 $\mu$m or less, and a sensor head size (an arrow portion in Fig. 3) of 26 mm in diameter.

As shown in Fig. 1(a), the measurement of the thickness was performed at 60 points at intervals of 1 mm in the vertical direction from a start point less than 1 mm (however, not 0 mm) from the upper side. The measurement of the vertical line was performed for 12 lines. The first line was located 2.5 mm away from the left side, and measurement lines were provided at intervals of 5 mm thereafter. Further, as shown in Fig. 1(b), the measurement of the thickness was performed at 60 points at intervals of 1 mm in the horizontal direction from a start point less than 1 mm (however, not 0 mm) from the left side. The measurement of the horizontal line was also performed for 12 lines. The first line was located 2.5 mm away from the upper side, and measurement lines were provided at intervals of 5 mm thereafter. In this manner, the thickness was measured at 1440 points in the plane direction of the copper-clad laminate (however, even in a case where there was a point where the measurement points overlapped in the vertical and horizontal measurement lines, each point was counted as one point).

For each of the four measurement substrates (N1 to N4), the maximum thickness and the minimum thickness were extracted from the measured thicknesses at 1440 points, and thereby the absolute values of the differences between the maximum values and the minimum values of the thicknesses at N1 to N4 and the average values of the absolute values were determined. Further, the average thickness of all the points measured for N1 to N4 was calculated, and this was taken as the average thickness of the copper-clad laminate.

In addition, from these numerical values, a value obtained by the following formula was determined.

(Average value of "absolute values of differences between maximum value and minimum value of thicknesses" in N1 to N4) × 100/(average thickness of copper-clad laminate)

[4. Variation in Rate of Dimensional Change of Copper-Clad Laminate]

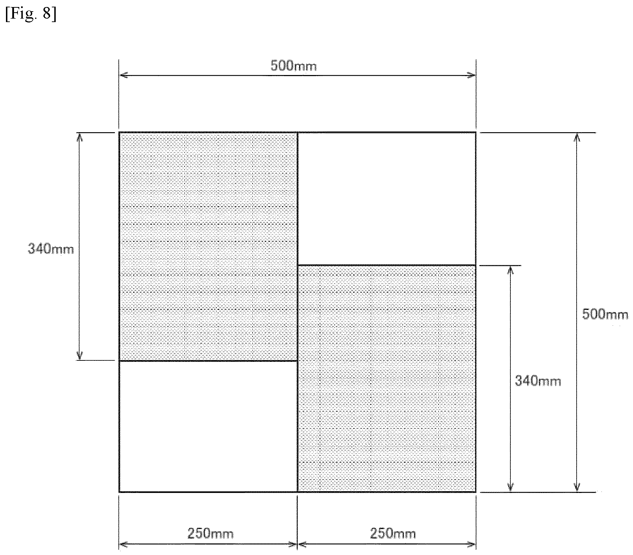

Two sheets of the copper-clad laminate produced in each example were prepared, and two sheets were cut out from each of the two sheets to have a size of 340 mm × 250 mm as shown in Fig. 8 (four sheets in total), and used as an evaluation substrate. For the four evaluation substrates, a total of four reference holes were provided at the 1 cm in the vertical direction and the 1 cm in the horizontal direction from the four corners, and the distances between adjacent holes were measured using a CNC image measuring machine (manufactured by Mitutoyo Corporation, trade name: QV-H606T1L-D), and the values were defined as "reference dimensions".

The evaluation substrate thus obtained was immersed in a copper etching solution (type of chemical solution: ammonium persulfate, temperature: 40°C, treatment time: 5 minutes) to remove the copper foil of the evaluation substrate.

Subsequently, the evaluation substrate from which the copper foil was removed by etching was heated at 180°C for 1 hour in the air, then allowed to cool to 25°C, and heated again at 180°C for 1 hour in the air. Thereafter, the distance between adjacent holes was measured by the same method as described above, and the value was defined as the "dimension after heating".

From the respective dimensions obtained above, the rate of dimensional change after heating was calculated for the four evaluation substrates based on the following formula.

Rate of dimensional change (%) = ((dimension after heating) - (reference dimension)) × 100/(reference dimension)

After calculating the rates of dimensional change of the four evaluation substrates (two data in the vertical direction and two data in the horizontal direction per one substrate), the standard deviation (σ value) was determined, and the obtained standard deviation (σ value) was used as an index of the variation in the rate of dimensional change. The variation in the rate of dimensional change is preferably 0.005% or less.

[5. Variation in Amount of Warpage of Semiconductor Package]

As shown in Fig. 7, four sheets cut out to a size of 60 mm × 60 mm from the four corners of the copper-clad laminate produced in each example were used as core substrates.

Using a build-up material (manufactured by Ajinomoto Co., Inc., trade name "GX92", thickness: 30 $\mu$m) (hereinafter, also referred to as "BU"), copper foil (manufactured by Mitsui Mining & Smelting Co., Ltd., trade name "3EC-M3-VLP", thickness: 12 $\mu$m), and a solder resist (manufactured by Resonac Corporation, trade name "SR-7300") (hereinafter, also referred to as "SR") were used to produce a substrate having the following layer configuration (a rectangle having an outer shape of 60 mm × 60 mm in plan view) on both surfaces of one core substrate, and a total of four similar substrates were produced.

(Layer Configuration of Substrate)

SR/copper foil (residual copper ratio 65%)/BU/BU/copper foil (residual copper ratio 100%)/BU/BU/copper foil (residual copper ratio 100%)/BU/BU/core substrate/BU/BU/copper foil (residual copper ratio 100%)/BU/BU/copper foil (residual copper ratio 100%)/BU/BU/copper foil (residual copper ratio 65%)/SR

In the above substrate, the thickness of the SR is 20 $\mu$m, and the radius of the solder resist opening is 100 $\mu$m. Further, a pad having a pad diameter of 150 $\mu$m and a pad pitch of 200 $\mu$m was provided.

The respective layers were laminated by the following procedures (1) to (5).

(1) Two sheets of build-up materials were laminated on each of both surfaces of the metal-clad laminate obtained in each example, a copper foil was superimposed on each of the exposed surfaces of the build-up materials on both surfaces, and then press-molding was performed under the conditions of 180°C, 0.5 MPa, and 90 minutes.
(2) Two sheets of build-up materials were further laminated on each of both surfaces of the obtained laminate, a copper foil was superimposed on each of the exposed surfaces of the build-up materials on both surfaces, and then press-molding was performed under the same conditions as described above.

(3) The same operation as in (2) above was carried out, and two sheets of build-up materials and copper foil were further laminated on both surfaces.

(4) The copper foils on both surfaces of the laminate obtained in (3) above were etched so as to obtain a predetermined pattern.

(5) A solder resist layer provided with a predetermined opening was formed on both surfaces of the laminate subjected to (4) above using the solder resist.

Next, a semiconductor chip made of silicon was mounted at the center of one surface of the substrate obtained above. The semiconductor chip was mounted by bonding a bump provided on the circuit surface side of the semiconductor chip and a pad of the substrate by a TCB (Thermal Compression Bonding) method. The configuration of the semiconductor chip is as follows.

(Configuration of Semiconductor Chip)

- Chip size: a rectangle of 25 mm × 25 mm in plan view, thickness 0.725 mm
- Bump pitch: 200 $\mu$m
- Bump metal: Sn-Ag solder alloy is mounted on Cu pillar
- Bump height: Cu pillar; 45 $\mu$m, Sn-Ag solder alloy; 15 $\mu$m
- Bump size: diameter 90 $\mu$m

After that, the gap between the semiconductor chip and the substrate was sealed with a liquid sealing material (manufactured by Resonac Corporation, trade name "CEL-C-3730 series") to obtain a semiconductor package. The same operation was performed on all of the four substrates to produce a total of four semiconductor packages.

The maximum amounts of warpage at 25°C and 260°C of each of the four semiconductor packages obtained above was measured using a warpage measuring device (trade name "TherMoire", manufactured by Akrometrix, Inc.). The temperature raising rate was set to 20°C per minute.

Next, an average value in the four semiconductor packages was obtained from the maximum amounts of warpage at 25°C and 260°C of each of the four semiconductor packages, and a standard deviation ($\sigma$ value) with respect to the average value was calculated, which was used as an index of variation in the amount of warpage of the semiconductor package. The standard deviation ($\sigma$ value) was rounded off to the first decimal place and shown in Table 1.

It can be said that the smaller the standard deviation ($\sigma$ value) is, the smaller the variation in the amount of warpage of the semiconductor package is. The standard deviation ($\sigma$ value) is preferably 10 $\mu$m or less, more preferably 8 $\mu$m or less, and still more preferably 6 $\mu$m or less.

The glass cloth used in each example is shown below.

(i) Glass cloth "IPC #2116" (manufactured by Nitto Boseki Co., Ltd., basis weight: 104 g/m$^2$, substrate width: 530 mm, thickness: 91 $\mu$m)

(ii) Glass cloth "IPC #2118" (manufactured by Nitto Boseki Co., Ltd., basis weight: 112 g/m$^2$, substrate width: 530 mm, thickness: 92 $\mu$m)

The thickness of each glass cloth is the average value of values obtained by measuring arbitrary five portions with a micrometer "MDC-25MX" (manufactured by Mitutoyo Corporation).

Production Example 1

(Production of Resin Varnish A)

60 parts by mass of a phenol-novolac type epoxy resin "EPICLON (registered trademark) N-770" (manufactured by DIC Corporation, epoxy equivalent: 188 g/eq), 40 parts by mass of a biphenyl-aralkyl type phenol resin (manufactured by Meiwa Kasei Co., Ltd. , trade name: MEH-7700), 17.5 parts by mass of aluminum hydroxide, 86 parts by mass of fused silica, 0.5 parts by mass of 2-methylimidazole, and methyl isobutyl ketone and cyclohexanone as diluent solvents were added and mixed to produce a resin varnish A having a solid concentration of 65% by mass (content of aluminum hydroxide: 8% by volume, content of fused silica: 32% by volume).

Production Example 2

(1. Production of Modified Maleimide Resin)

In a reaction vessel having a capacity of 2 L capable of being heated and cooled equipped with a thermometer, a stirring device, and a water quantitative meter having a reflux condenser, 595.8 g of bis(4-maleimidophenyl)methane, 54.2 g of 4,4'-diaminodiphenylmethane, and 350.0 g of propylene glycol monomethyl ether were placed and then reacted for 5 hours under refluxing, so as to obtain a solution of a modified maleimide resin (solid concentration: 65% by mass).

(2. Production of Resin Varnish B)

107 parts by mass of the solution of a modified maleimide resin above, 30 parts by mass of a tetrafunctional naphthalene type epoxy resin "EXA-4710" (manufactured by DIC Corporation), 17.5 parts by mass of aluminum hydroxide, 130 parts by mass of fused silica, 0.5 parts by mass of 2,4-diamino-6-[2'-undecylimidazolyl-(1')]-ethyl-s-triazine, and methyl isobutyl ketone and cyclohexanone as diluent solvents were added and mixed to produce a resin varnish B having a solid concentration of 65% by mass (content of aluminum hydroxide: 8% by volume, content of fused silica: 41.5% by volume).

Example 1

(1. Production of Resin Film)

The resin varnish A obtained in Production Example 1 was coated on a PET film (manufactured by Toray Industries, Inc., thickness: 50 $\mu$m, trade name: S10) using a comma coater. At this time, the coating amount was regulated to make a coating width of 530 mm and a thickness after drying of 30 $\mu$m. Thereafter, the resultant was heated and dried at 130°C for 2 minutes to produce a resin film with a PET film.

(2. Production of Prepreg)

Next, the resin layer surface of the resin film with a PET film was disposed on both surfaces of a glass cloth "IPC #2116" (manufactured by Nitto Boseki Co., Ltd., basis weight: 104 g/m$^2$, substrate width: 530 mm, thickness: 91 $\mu$m) having a size of vertical 530 mm $\times$ horizontal 530 mm so as to be in contact with the glass cloth. This laminated body of "PET film/resin film/glass cloth/resin film/PET film" was heated and pressurized under vacuum using a vacuum laminating apparatus. According to the procedure, a prepreg with a PET film having the glass cloth impregnated with the thermosetting resin composition of the resin film was obtained. The condition of vacuum lamination was a heating platen temperature of 130°C, a crimping pressure of 0.5 MPa, a vacuum degree of 100 kPa or less, a vacuum time of 30 seconds, and a heating time of 30 seconds. The PET film was released from the resulting prepreg with a PET film, so as to obtain a prepreg 1 (thickness: 125 $\mu$m).
The thickness of the prepreg 1 was the average value of values obtained by measuring arbitrary five portions with a horizontal pedestal and a digimatic indicator (manufactured by Mitutoyo Corporation).
The content ratio of the thermosetting resin composition in the prepreg 1 was calculated in the following manner. The mass ($w_r$) of the resin film was calculated by subtracting the total mass of the two plies of the PET films from the total mass of two plies of the resin films with a PET film used in producing the prepreg 1. The content ratio of the thermosetting resin composition was obtained using the mass ($w_r$) of the resin film and the mass ($w_p$) of the prepreg 1 according to the following equation.

$$\text{Content ratio(\% by mass) of thermosetting resin composition} = (w_r/w_p) \times 100$$

The resulting prepreg 1 was subjected to the above-described respective measurements. The results are shown in Table 1. The surface observation image of the prepreg converted to monochrome mode used in calculating the existing ratio of the impregnated region is shown in Fig. 6. The observation condition of the surface of the prepreg was as described above, and the exposure time in imaging the surface was 85 ms.

(3. Production of Copper-Clad Laminate)

12 plies of the resulting prepreg 1 were laminated, and copper foils having a thickness of 12 $\mu$m "GTS-12" (manufactured by Furukawa Electric Co., Ltd.) were disposed on the upper and lower surfaces of the laminate. Next, pressing was performed under the following conditions, and an end portion of the resulting copper-clad laminate was cut to produce a copper-clad laminate 1 having a size of 500 mm $\times$ 500 mm. The resulting copper-clad laminate 1 was subjected to the above-described respective measurements and evaluations. The results are shown in Table 1.

- Press Condition -

Heating conditions (resin varnish A): the temperature was raised from 25°C to 185°C at a temperature raising rate of 3°C/min, held at 185°C for 90 minutes, and then cooled for 30 minutes.
Pressure condition (pressure applied to 12 plies of prepreg sandwiched between copper foils): 4 MPa (from the start of temperature raising to the end of cooling)

Example 2

A copper-clad laminate 2 was produced by performing the same procedure as in Example 1 except that the number of lamination plies of the prepreg was changed to six in the production of the copper-clad laminate of Example 1, and the above-described respective measurements and evaluations were performed. The results are shown in Table 1.

Example 3

A prepreg 3 (thickness: 120 $\mu$m) was produced by performing the same procedure as in Example 1 except that the heating platen temperature was changed to 140°C, the vacuum time was changed to 50 seconds, and the heating time was changed to 50 seconds among the conditions for the vacuum lamination in the production of the prepreg in Example 1. In addition, a copper-clad laminate 3 was produced by performing the same procedure as in Example 1 except that in the production of the copper-clad laminate in Example 1, the prepreg 3 was used instead of the prepreg 1, and the number of lamination plies of the prepreg was changed to 14. The prepreg 3 and the copper-clad laminate 3 were subjected to the above-described respective measurements and evaluations. The results are shown in Table 1.

Example 4

A prepreg 4 (thickness: 115 $\mu$m) was produced by performing the same procedure as in Example 1 except that the heating platen temperature was changed to 150°C among the conditions for the vacuum lamination in the production of the prepreg in Example 1. In addition, a copper-clad laminate 4 was produced by performing the same procedure as in Example 1 except that in the production of the copper-clad laminate in Example 1, the prepreg 4 was used instead of the prepreg 1, and the number of lamination plies of the prepreg was changed to 6. The prepreg 4 and the copper-clad laminate 4 were subjected to the above-described respective measurements and evaluations. The results are shown in Table 1.

Example 5

A prepreg 5 (thickness: 110 $\mu$m) was produced by performing the same procedure as in Example 1 except that in the production of the resin film of Example 1, the resin varnish B was used instead of the resin varnish A, and in the production of the prepreg, the heating platen temperature was changed to 150°C, the crimping pressure was changed to 0.7 MPa, the vacuum time was changed to 60 seconds, and the heating time was changed to 60 seconds among the conditions for the vacuum lamination. A copper-clad laminate 5 was produced by performing the same procedure as in Example 1 except that in the production of the copper-clad laminate in Example 1, the prepreg 5 was used instead of the prepreg 1, and the press condition was changed as shown below. The prepreg 5 and the copper-clad laminate 5 were subjected to the above-described respective measurements and evaluations. The results are shown in Table 1.

- Press Condition -

Heating conditions (resin varnish B): the temperature was raised from 25°C to 230°C at a temperature raising rate of 3°C/min, held at 230°C for 90 minutes, and then cooled for 30 minutes.

Example 6

A prepreg 6 (thickness: 125 $\mu$m) was produced by performing the same procedure as in Example 1 except that in the production of the resin film of Example 1, the PET film was changed to a PET film (manufactured by Toray Industries, Inc., thickness: 50 $\mu$m, support, trade name: Lumirror (registered trademark) #50-X44), and the resin varnish B was used instead of the resin varnish A. In addition, a copper-clad laminate 6 was produced by performing the same procedure as in Example 1 except that in the production of the copper-clad laminate in Example 1, the prepreg 6 was used instead of the prepreg 1, the number of lamination plies of the prepreg was changed to 6, and the press condition was changed as shown below. The evaluation results of the prepreg 6 and the copper-clad laminate 6 are shown in Table 1.

- Press Condition -

Heating conditions (resin varnish B): the temperature was raised from 25°C to 230°C at a temperature raising rate of 3°C/min, held at 230°C for 90 minutes, and then cooled for 30 minutes.

Example 7

A prepreg 7 (thickness: 120 $\mu$m) was produced by performing the same procedure as in Example 3 except that in the production of the prepreg in Example 3, the glass cloth "IPC #2116" was changed to a glass cloth "IPC #2118" (manufactured by Nitto Boseki Co., Ltd., basis weight: 112 g/m$^2$, substrate width: 530 mm, thickness: 92 $\mu$m), and the heating platen temperature was changed to 145°C among the conditions for the vacuum lamination. In addition, a copper-clad laminate 7 was produced by performing the same procedure as in Example 3 except that in the production of the copper-clad laminate in Example 3, the prepreg 7 was used instead of the prepreg 3. The evaluation results of the prepreg 7 and the copper-clad laminate 7 are shown in Table 1.

Example 8

A prepreg 8 (thickness: 130 $\mu$m) was produced by performing the same procedure as in Example 5 except that in the production of the prepreg in Example 5, the glass cloth "IPC #2116" was changed to a glass cloth "IPC #2118" (manufactured by Nitto Boseki Co., Ltd., basis weight: 112 g/m$^2$, substrate width: 530 mm, thickness: 92 $\mu$m), and the heating platen temperature was changed to 110°C, the crimping pressure was changed to 0.3 MPa, the vacuum time was changed to 20 seconds, and the heating time was changed to 20 seconds among the conditions for the vacuum lamination. In addition, a copper-clad laminate 8 was produced by performing the same procedure as in Example 5 except that in the production of the copper-clad laminate in Example 5, the prepreg 8 was used instead of the prepreg 5, and the number of lamination plies of the prepreg was changed to 6. The measurement and evaluation results of the prepreg 8 and the copper-clad laminate 8 are shown in Table 1.

Comparative Example 1

A glass cloth "IPC #2116" (manufactured by Nitto Boseki Co., Ltd., basis weight: 104 g/m$^2$, substrate width: 530 mm, thickness: 91 $\mu$m) was immersed in the resin varnish A prepared in Production Example 1, then taken out therefrom, and dried by heating to 140°C for 3.5 minutes to obtain a prepreg X (thickness: 180 $\mu$m). A copper-clad laminate X was produced by performing the same procedure as in Example 1 except that in the production of the copper-clad laminate in Example 1, the prepreg X was used instead of the prepreg 1. The measurement and evaluation results of the prepreg X and the copper-clad laminate X are shown in Table 1.
The existing ratio of the impregnated region of the prepreg X was unable to determine since the surface of the prepreg was not in focus in observing with the optical microscope due to the large surface waviness.

[Table 1]

Table 1

| | | Examples | | | | |
|---|---|---|---|---|---|---|
| | | 1 | 2 | 3 | 4 | 5 |
| Resin varnish | Type of resin varnish | A | A | A | A | B |

(continued)

| | | | Examples | | | | |
|---|---|---|---|---|---|---|---|
| | | | 1 | 2 | 3 | 4 | 5 |
| Prepreg | Type of glass cloth | | #2116 | #2116 | #2116 | #2116 | #2116 |
| | Thickness (μm) of glass cloth | | 91 | 91 | 91 | 91 | 91 |
| | Content ratio (% by mass) of thermosetting resin composition | | 50 | 50 | 50 | 50 | 50 |
| | Surface waviness Wa (μm) | | 0.5 | 0.5 | 0.8 | 1.8 | 3.2 |
| | Existing ratio (%) of impregnated region | | 62 | 62 | 87 | 92 | 95 |
| | Number of lamination plies of prepreg at the time of producing copper-clad laminate | | 12 | 6 | 14 | 6 | 12 |
| Copper-clad laminate | Average thickness (μm) | | 1,242 | 626 | 1,456 | 630 | 1,237 |
| | Absolute value of difference between maximum value and minimum value of thickness (μm) | N1 | 3.5 | 2.7 | 11.2 | 5.3 | 22.2 |
| | | N2 | 3.8 | 2.3 | 9.4 | 5.1 | 13.7 |
| | | N3 | 4.2 | 2.4 | 9.4 | 6.3 | 17.1 |
| | | N4 | 3.2 | 2.3 | 10.7 | 5.5 | 14.9 |
| | | Average value in N1 to N4 | 3.7 | 2.4 | 10.2 | 5.6 | 17.0 |
| | (Average value in N1 to N4) × 100/(average thickness of copper-clad laminate) (%) | | 0.3 | 0.4 | 0.7 | 0.9 | 1.4 |
| Evaluation results | Variation (%) in rate of dimensional change of copper-clad laminate | | 0.001 | 0.002 | 0.002 | 0.002 | 0.004 |
| | Variation (μm) in amount of warpage of semiconductor package [25°C] | | 5 | 7 | 5 | 9 | 7 |
| | Variation (μm) in amount of warpage of semiconductor package [260°C] | | 4 | 5 | 4 | 6 | 5 |
| *1: Not measurable | | | | | | | |

Table 1 (continued)

| | | Examples | | | Comparative Example |
|---|---|---|---|---|---|
| | | 6 | 7 | 8 | 1 |
| Resin varnish | Type of resin varnish | B | A | B | A |
| Prepreg | Type of glass cloth | #2116 | #2118 | #2118 | #2116 |
| | Thickness (μm) of glass cloth | 91 | 92 | 92 | 91 |
| | Content ratio (% by mass) of thermosetting resin composition | 50 | 48 | 48 | 50 |
| | Surface waviness Wa (μm) | 0.6 | 0.9 | 0.4 | 5.7 |
| | Existing ratio (%) of impregnated region | 70 | 89 | 43 | -*1 |
| | Number of lamination plies of prepreg at the time of producing copper-clad laminate | 6 | 14 | 6 | 12 |

(continued)

| | | | Examples | | | Comparative Example |
|---|---|---|---|---|---|---|
| | | | 6 | 7 | 8 | 1 |
| Copper-clad laminate | Average thickness (μm) | | 624 | 1,454 | 625 | 1,231 |
| | Absolute value of difference between maximum value and minimum value of thickness (μm) | N1 | 2.8 | 13.0 | 2.3 | 76.0 |
| | | N2 | 3.0 | 11.2 | 2.1 | 15.5 |
| | | N3 | 3.3 | 5.6 | 1.9 | 28.3 |
| | | N4 | 3.1 | 14.1 | 2.5 | 22.5 |
| | | Average value in N1 to N4 | 3.1 | 11.0 | 2.2 | 35.6 |
| | (Average value in N1 to N4) × 100/(average thickness of copper-clad laminate) (%) | | 0.5 | 0.8 | 0.4 | 2.9 |
| Evaluation results | Variation (%) in rate of dimensional change of copper-clad laminate | | 0.003 | 0.002 | 0.002 | 0.008 |
| | Variation (μm) in amount of warpage of semiconductor package [25°C] | | 5 | 4 | 7 | 13 |
| | Variation (μm) in amount of warpage of semiconductor package [260°C] | | 4 | 3 | 6 | 11 |
| *1: Not measurable | | | | | | |

From Table 1, it can be seen that the copper-clad laminates produced in Examples had an average thickness of 400 μm or more, and the average value of the absolute values of the differences between the maximum values and the minimum values of the thicknesses was 20 μm or less, and the semiconductor packages produced using the copper-clad laminates had a small variation in the amount of warpage. In addition, the copper-clad laminates also had a small variation in the rate of dimensional change after etching and heat treatment.

On the other hand, in the copper-clad laminates produced in Comparative Examples, the average value of the absolute values of the differences between the maximum values and the minimum values of the thicknesses exceeded 20 μm, and it can be seen that the semiconductor packages produced using the copper-clad laminates tended to have a large variation in the amount of warpage. In addition, the copper-clad laminates tended to have a large variation in the rate of dimensional change after etching and heat treatment.

## Claims

1. A metal-clad laminate comprising a metal foil and a cured product of one or more plies of a prepreg, wherein an average thickness measured according to the following method using a laser displacement meter is 400 μm or more, and an average value of absolute values of a difference between a maximum value and a minimum value of a thickness is 20 μm or less: (method for measuring thickness of metal-clad laminate)

the thickness is measured by cutting out four measurement substrates each having a size of 60 mm (vertical) × 60 mm (horizontal) in a plane direction from an arbitrary portion of the metal-clad laminate; the measurement is performed at intervals of 1 mm in the vertical direction from a start point of less than 1 mm (however, not 0 mm) from the upper side; the measurement of the vertical line is performed for 12 lines; the first line is located 2.5 mm away from the left side, and measurement lines are provided at intervals of 5 mm thereafter; further, the thickness is measured at intervals of 1 mm in the horizontal direction from a start point of less than 1 mm (however, not 0 mm) from the left side; the measurement of the horizontal line is also performed for 12 lines; the first line is located 2.5 mm away from the upper side, and measurement lines are provided at intervals of 5 mm thereafter; the absolute value of the difference between the maximum value and the minimum value of the thickness of each of the four measurement substrates and the average value of the absolute values are obtained by extracting the maximum thickness and the minimum thickness from the thicknesses of all the points measured for each of the four measurement substrates; and further, the average thickness of all the points measured for the four measurement substrates is calculated, and this is taken as the average thickness of the metal-clad laminate.

2. The metal-clad laminate according to claim 1, wherein a value calculated from the following formula is 2.0% or less:

(average value of absolute values of differences between maximum value and minimum value of thicknesses) $\times$ 100/(average thickness of metal-clad laminate).

3. The metal-clad laminate according to claim 1, wherein the average value of the absolute values of the differences between the maximum value and the minimum value of the thicknesses is 16 $\mu$m or less.

4. The metal-clad laminate according to claim 1, wherein the prepreg is a prepreg containing a fiber substrate having a thickness of 40 $\mu$m or more and a thermosetting resin composition.

5. The metal-clad laminate according to claim 1, wherein the metal foil has a thickness of 1 to 200 $\mu$m.

6. A printed wiring board comprising the metal-clad laminate according to claim 1.

7. A semiconductor package comprising the printed wiring board according to claim 6 and a semiconductor element.

[Fig. 1]

[Fig. 2]

[Fig. 3]

[Fig. 4]

[Fig. 5]

Fiber substrate

Resin thickness T1
overlaid on fiber substrate (front)

Thickness of fiber substrate

Resin thickness T2
overlaid on fiber substrate (back)

[Fig. 6]

[Fig. 7]

[Fig. 8]

# EP 4 631 718 A1

## INTERNATIONAL SEARCH REPORT

| | International application No. |
|---|---|
| | **PCT/JP2023/043681** |

### A. CLASSIFICATION OF SUBJECT MATTER

*B32B 15/08*(2006.01)i; *H05K 1/03*(2006.01)i
FI: B32B15/08 105Z; H05K1/03 610T; H05K1/03 610G; H05K1/03 630H

According to International Patent Classification (IPC) or to both national classification and IPC

### B. FIELDS SEARCHED

Minimum documentation searched (classification system followed by classification symbols)

B32B15/08; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/144861 A1 (HITACHI CHEMICAL COMPANY, LTD.) 16 July 2020 (2020-07-16) claims, paragraphs [0001], [0007], [0010]-[0044], fig. 1-6 | 1-7 |
| X | WO 2022/059716 A1 (SHOWA DENKO MATERIALS CO., LTD.) 24 March 2022 (2022-03-24) claims, paragraphs [0001]-[0006], [0016], [0017], [0090]-[0128], fig. 1-4 | 1-7 |
| X | JP 9-227699 A (MATSUSHITA ELECTRIC WORKS, LTD.) 02 September 1997 (1997-09-02) claims, paragraphs [0001]-[0007], [0027]-[0049] | 1-7 |
| X | JP 9-94915 A (HITACHI CHEM. CO., LTD.) 08 April 1997 (1997-04-08) claims, paragraphs [0001]-[0012], fig. 1 | 1-7 |
| P, X | WO 2022/254587 A1 (SHOWA DENKO MATERIALS CO., LTD.) 08 December 2022 (2022-12-08) claims, paragraphs [0001]-[0075], fig. 1-4 | 1-7 |

☑ Further documents are listed in the continuation of Box C.   ☑ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **06 February 2024** | **20 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| --- |
| **PCT/JP2023/043681** |

### C.    DOCUMENTS CONSIDERED TO BE RELEVANT

| Category* | Citation of document, with indication, where appropriate, of the relevant passages | Relevant to claim No. |
| --- | --- | --- |
| A | WO 2022/059711 A1 (SHOWA DENKO MATERIALS CO., LTD.) 24 March 2022 (2022-03-24) <br> entire text | 1-7 |
| A | JP 2009-166404 A (SUMITOMO BAKELITE CO., LTD.) 30 July 2009 (2009-07-30) <br> entire text | 1-7 |
| A | CN 104830059 A (SHENGYI TECHNOLOGY (SUZHOU) CO., LTD.) 12 August 2015 (2015-08-12) <br> entire text | 1-7 |

Form PCT/ISA/210 (second sheet) (July 2022)

# EP 4 631 718 A1

| INTERNATIONAL SEARCH REPORT | | | | International application No. | |
|---|---|---|---|---|---|
| Information on patent family members | | | | PCT/JP2023/043681 | |

| Patent document cited in search report | | | Publication date (day/month/year) | Patent family member(s) | | | Publication date (day/month/year) |
|---|---|---|---|---|---|---|---|
| WO | 2020/144861 | A1 | 16 July 2020 | CN | 113272131 | A | |
| | | | | KR | 10-2021-0113229 | A | |
| WO | 2022/059716 | A1 | 24 March 2022 | KR | 10-2023-0058428 | A | |
| | | | | TW | 202216868 | A | |
| | | | | JP | 2023-81928 | A | |
| JP | 9-227699 | A | 02 September 1997 | (Family: none) | | | |
| JP | 9-94915 | A | 08 April 1997 | (Family: none) | | | |
| WO | 2022/254587 | A1 | 08 December 2022 | TW | 202248318 | A | |
| WO | 2022/059711 | A1 | 24 March 2022 | KR | 10-2023-0069944 | A | |
| | | | | TW | 202212151 | A | |
| JP | 2009-166404 | A | 30 July 2009 | (Family: none) | | | |
| CN | 104830059 | A | 12 August 2015 | (Family: none) | | | |

Form PCT/ISA/210 (patent family annex) (July 2022)

32

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015189834 A

- WO 2012099134 A